Europäisches Patentamt

European Patent Office

Office européen des brevets

(11) Publication number: **0 410 297 A1**

# EUROPEAN PATENT APPLICATION

(21) Application number: 90113813.1

(22) Date of filing: 19.07.90

(51) Int. Cl.⁵: **H03L 7/08**, H04L 7/033

(30) Priority: 21.07.89 IT 4821889

(43) Date of publication of application:
30.01.91 Bulletin 91/05

(84) Designated Contracting States:
DE FR GB NL SE

(71) Applicant: SELENIA INDUSTRIE
ELETTRONICHE ASSOCIATE S.p.A.
Via Tiburtina, KM 12.400
I-00131 Roma(IT)

(72) Inventor: Masdea, Arturo
Via Ugo La Malfa, 9
I-00040 Grottaferrata(IT)
Inventor: Masucci, Rosanna
Via della Tecnica, 52
I-00040 Pomezia(IT)
Inventor: Bartolomei, Roberto
Via Cese, 27
I-00040 Ariccia(IT)

(74) Representative: Gustorf, Gerhard, Dipl.-Ing.
Patentanwalt Dipl.-Ing. Gerhard Gustorf
Bachstrasse 6 A
D-8300 Landshut(DE)

(54) **Circuit to be used in data transmission systems, which regenerates the clock signal starting from a given message.**

(57) Circuit for the regeneration of the clock signal within a message containing a preamble and random data. No assumptions on the message structure is required for the operation of such circuit, as this operates on the autocorrelation principle, which frees the datum format from the VCO which reconstructs the clock signal.

Such device finds its preferred application in a data transmission system and therefore belongs to the information and electrical communications theory field.

It is essentially formed by a phase correlator (1), a filter (2), an amplifying stage (3) and a VCO, where the correlator is in turn formed by a delay line (7), two multiplying elements (5) and a sampled delay element and may be implemented in a digital or analogue form.

FIGURE 1

EP 0 410 297 A1

## CIRCUIT TO BE USED IN DATA TRANSMISSION SYSTEMS, WHICH REGENERATES THE CLOCK SIGNAL STARTING FROM A GIVEN MESSAGE

The invention concerns a circuit which is capable of regenerating the clock signal within a given message. It makes possible clock reconstruction in very short times starting from any coded signal without the need for a preamble.

The invention belongs to the information and electrical communications field.

At present, clock regeneration problems are solved by devices such as:
- PIL
- EARLY-LATE GATE
- COSTAS LOOP.

These systems have message structure (PLL) or frequency (EARLY-LATE) or lock on times (COSTAS LOOP). Therefore, in more general applications (transmission on avionic busses) where there is a need for strict respect for the limitations above, conventional systems prove inadequate and cannot be applied.

The invention presented here solves such problems, offering a further advantage of particular importance to avionic systems which require high reliability and small dimensions.

The aim of this invention are:
- clock data extraction from a message preceded or not preceded by a preamble;
- operation on random data without any particular format defined during the design phase;
- keep a preset tracking error compatible with the required system specifications.

The frequency range of the device is between a few Hz and tens of MHz. The device is simple and can be implemented by means of asic or hybrid techniques.

The invention will now be described for illustrative and non limiting purposes with reference to the figures attached.
- Figure 1 Block diagram of the clock regenerator.
- Figure 2 Block diagram of the phase correlator.
- Figure 3 Waveforms associated to the phase correlator.
- Figure 4 Circuit diagram of the device shown in Figure 2

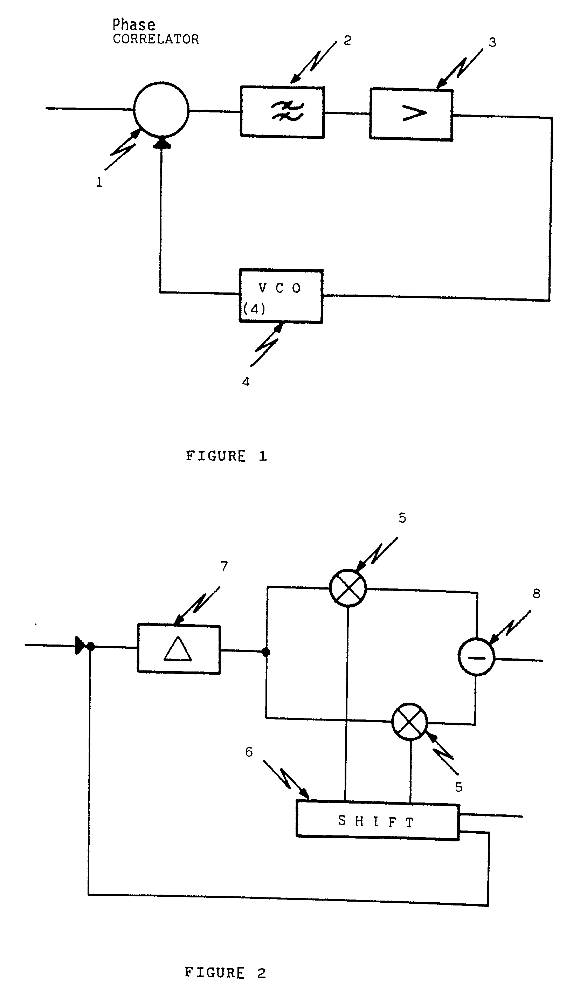

Figure 1 shows a block diagram of the device, where we can see:
The phase correlator (1);
- The filter (2);
- The amplifying stage (3);
- The VCO (4).

Figure 2 breaks element (1) of Figure 1 into the following, sub assemblies:
- mixer (5)
- shift register (6)

- delay line (7)
- differential amplifier (8).

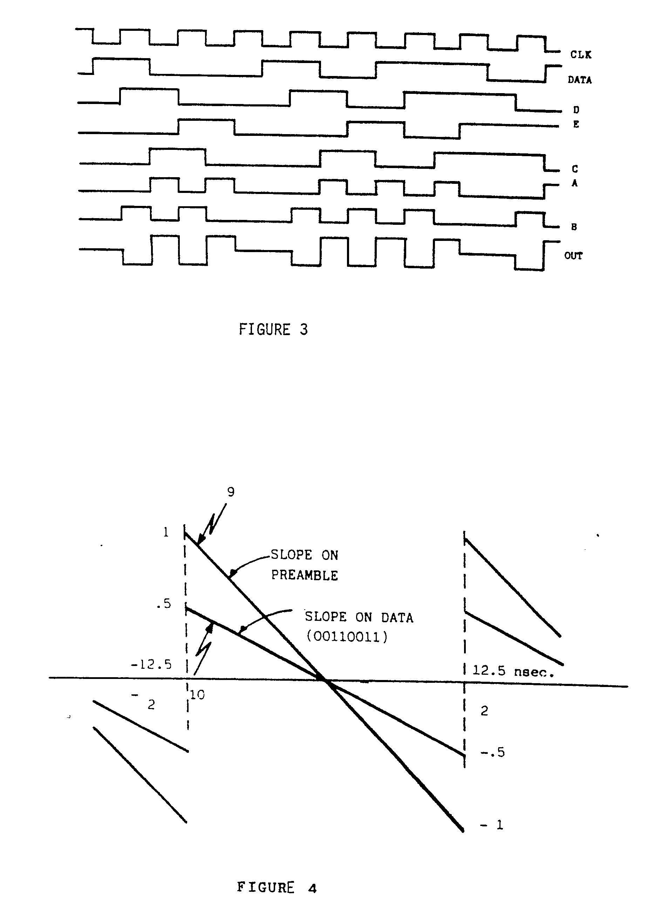

Figure 3 shows the signals present at the following points:
- mixer outputs (A,B);
- shift register output (D,E)
- differential amplifier output (AU)
- input (DATA)
- mixer input (C)
- clock (CLK)

Figure 4 shows the correlation characteristic, where we can see:
- gain during preamble (9);
- gain during message (10)
- exclusive or (11)
- flip-flop (12)
- difference element (13)
- delay line (14).

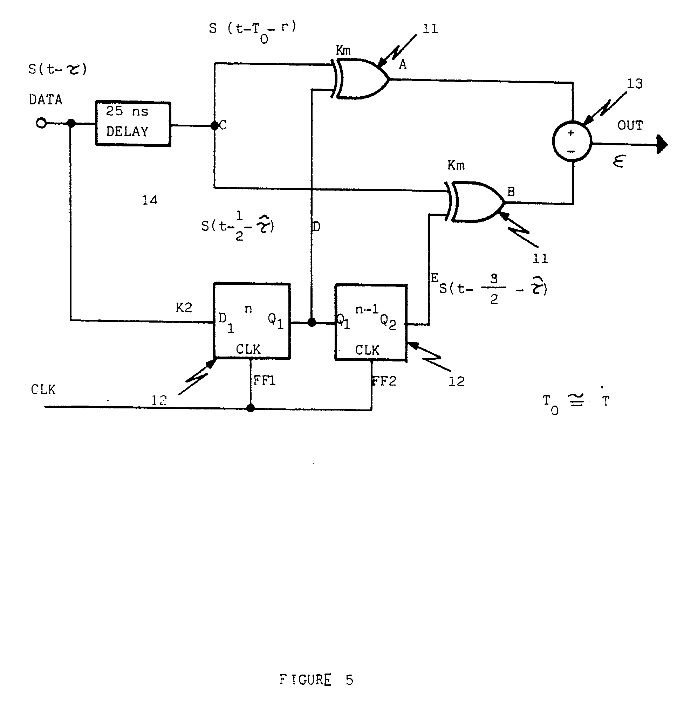

Figure 5 shows the actual circuit diagram of the correlator shown in figure 2.

The operation of the device may be briefly outlined by noting that the input signal is correlated with two identical signals synchronised by the clock, one ahead of the other by one clock step. This way there is a balanced situation only if the signal at the output of the delay line is lagging the two synchronous copies by 90 degrees.

The effect can be easily visualised when the input datum is deterministic; when it becomes random, the differentiating element output produces time intervals when the error signal is zero.

At any rate no violent transient at the correlator output takes place when the data changes, but rather there is a rapid adjustment which eliminates the transients, due to the fact that after the time intervals at which the error signal is zero, the error signal always starts with the same phase which it would have had in the presence of deterministic data.

This is what makes tracking possible during the random datum, with no loss of information which may have been acquired during the preamble.

## Claims

1. Circuit for the regeneration of the clock signal starting from a message , suitable for a groundbased, shipborne and avionic data communications system, which consists basically of a phase correlator (1), a filter (2) an amplifier (3) and a VCO (4).

2. Circuit as per claim 1, where the correlator (1) is (Figure 2) formed by a delay line(7), its multiplying elements (5), a shift register (6) (or sampled delay elements).

3. Circuit for the regeneration of the clock signal from a given message, suitable for insertion within a data communication system for ground, naval and avionic applications, as per the claims above, which may be implemented according to analogue or digital techniques.

FIGURE 1

FIGURE 2

4

FIGURE 3

FIGURE 4

FIGURE 5

# DOCUMENTS CONSIDERED TO BE RELEVANT

**EP 90113813.1**

| Category | Citation of document with indication, where appropriate, of relevant passages | Relevant to claim | CLASSIFICATION OF THE APPLICATION (Int. Cl.5) |
|---|---|---|---|
| X | CH - A5 - 625 922 (HASLER) * Abstract; page 2, right-hand column, line 34 - page 3, left-hand column, line 14; fig. 1,2 * | 1 | H 03 L 7/08 H 04 L 7/033 |
| A | | 2 | |
| Y | EP - A1 - 0 079 446 (INTERNATIONAL BUSINESS MACHINES) * Page 1, lines 3-12; page 4, line 26 - page 5, line 12; fig. 1 * | 1 | |
| Y | DE - B2 - 2 645 545 (THOMSON-CSF) * Claim 1; column 2, lines 30-50 * | 1 | |
| A | EP - A2 - 0 278 079 (INTERNATIONAL BUSINESS MACHINES) * Column 3, line 32 - column 4, line 3; fig. 1 * | 1 | **TECHNICAL FIELDS SEARCHED (Int. Cl.5)** H 03 L H 04 L G 01 R |
| A | US - A - 4 698 601 (AIZAWA) * Abstract; column 2, lines 59-66; fig. 1 * | 1 | |

The present search report has been drawn up for all claims

| Place of search | Date of completion of the search | Examiner |
|---|---|---|
| VIENNA | 16-11-1990 | HAJOS |

EPO FORM 1503 03.82 (P0401)